# EUROPÄISCHE PATENTSCHRIFT

(11) **EP 3 186 033 B1**
(45) Veröffentlichungstag und Bekanntmachung des Hinweises auf die Patenterteilung: **01.05.2019**
(21) Anmeldenummer: 15762933.8
(22) Anmeldetag: 21.08.2015
(51) Int. Cl.: B23K 1/00, C22C 9/02, C22C 9/04, C22C 13/00, B23K 35/26, B23K 35/30, B23K 35/362, B23K 35/02

(54) **LOTPASTE UND VERFAHREN ZUM STOFFSCHLÜSSIGEN VERBINDEN**
SOLDERING PASTE AND PROCESS OF COHESIVE CONNECTION
PÂTE À BRASER ET PROCÉDÉ DE CONNECTION COHÉSIVE

(30) Priorität: 27.08.2014 EP 14182395
(43) Veröffentlichungstag der Anmeldung: 05.07.2017
(73) Patentinhaber: Heraeus Deutschland GmbH & Co. KG, 63450 Hanau (DE)
(72) Erfinder: FRITZSCHE, Sebastian, 63454 Hanau (DE); SCHULZE, Jürgen, 14480 Potsdam (DE); TRODLER, Jörg, 63526 Erlensee (DE)
(74) Vertreter: Heraeus IP
(86) Internationale Anmeldenummer: PCT/EP2015/069217
(87) Internationale Veröffentlichungsnummer: WO 2016/030286

(56) Entgegenhaltungen:
- WO-A1-2011/009597
- DE-A1- 19 747 041
- US-A1- 2009 057 378

## Beschreibung

Die vorliegende Erfindung betrifft ein Verfahren zum stoffschlüssigen Verbinden eines elektronischen Bauteils mit einem Substrat, und eine Lotpaste, die bei diesem Verfahren zum Einsatz kommt.

WO 2011/009597 A1 offenbart ein Verfahren zum stoffschlüssigen Verbinden eines elektronischen Bauteils mit einem Substrat, bei dem man a) ein elektronisches Bauteil mit einer ersten zu verbindenden Oberfläche und ein Substrat mit einer zweiten zu verbindenden Oberfläche bereitstellt, b) auf wenigstens eine der zu verbindenden Oberflächen eine Lotpaste aufträgt, c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und d) die Anordnung aus c) verlötet, um eine stoffschlüssige Verbindung zwischen dem elektronischen Bauteil und dem Substrat zu erzeugen. Die Auftragsdicke der Lotpaste beträgt dabei wenigstens 20 µm. Die in dem Verfahren verwendete Lotpaste enthält (i) 10 - 30 Gew.-% (Gewichts-%) Kupferpartikel, (ii) 60 - 80 Gew.-% Partikel aus wenigstens einem Stoff, der aus der Gruppe ausgewählt ist, die aus Zinn und Zinn-Kupfer-Legierungen besteht, und (iii) 3 - 30 Gew.-% Flussmittel, wobei der mittlere Teilchendurchmesser der Kupferpartikel und der Partikel aus wenigstens einem Stoff, der aus der Gruppe ausgewählt ist, die aus Zinn und Zinn-Kupfer-Legierungen besteht, ≤ 15 µm beträgt.

DE19747041 A1 offenbart eine flussmittelfreie Hartlotpaste umfassend ein feinteiliges Lot auf Basis einer Kupfer-Phosphor-Legierung mit einem Anteil von 10 bis 20 Atom-% Phosphor, 2 bis 5 Atom-% Nickel, 0 bis 15 Atom-% Zinn, 0 bis 5,5 Atom-% Mangan, Rest Kupfer.

Die Anmelderin hat festgestellt, dass mit dem aus WO 2011/009597 A1 bekannten Verfahren überraschenderweise weiter verbesserte, insbesondere unter Hochtemperaturbedingungen im Bereich von beispielsweise 250 bis 300 °C zuverlässigere Lötverbindungen erhalten werden können, wenn man in der Lotpaste als Kupferpartikel jeweils einen Phosphorgehalt von > 0 bis ≤ 500 Gewichts-ppm aufweisende Partikel aus Kupfer bzw. aus kupferreichen Kupfer/Zinn- bzw. Kupfer/Zinklegierungen verwendet.

Die Erfindung betrifft daher ein Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Lotpaste appliziert,
c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und
d) die Anordnung aus c) bei einer im Bereich von 240 - 260 °C liegenden Löttemperatur verlötet, um eine stoffschlüssige Verbindung zwischen dem elektronischen Bauteil und dem Substrat zu erzeugen,
wobei die Lotpaste (i) 10 - 30 Gew.-% mindestens einer Art von jeweils einen Phosphoranteil von > 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 60 - 80 Gew.-% mindestens einer Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (iii) 3 - 30 Gew.-% Flussmittel enthält,
wobei der mittlere Teilchendurchmesser der metallischen Partikel (i) und (ii) ≤ 15 µm beträgt, und wobei die Auftragsdicke der Lotpaste wenigstens 20 µm beträgt,
wobei die kupferreichen Kupfer/Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen.

Die Erfindung betrifft auch eine Lotpaste, die (i) 10 - 30 Gew.-% mindestens einer Art von jeweils einen Phosphoranteil von > 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 60 - 80 Gew.-% mindestens einer Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (iii) 3 - 30 Gew.-% Flussmittel enthält, wobei der mittlere Teilchendurchmesser der metallischen Partikel (i) und (ii) ≤ 15 µm beträgt,
wobei die kupferreichen Kupfer/Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen.

Erfindungsgemäß wird unter elektronischem Bauteil ein Bestandteil einer elektrischen bzw. elektronischen Schaltung verstanden. Bei dem elektronischen Bauteil kann es sich beispielsweise um einen Chip, vorzugsweise einen Nacktchip (ungehauster Halbleiterchip), um eine Halbleiterdiode, um einen Transistor, um einen Widerstand oder um einen Kondensator handeln.

Im Rahmen der Erfindung wird unter Substrat ein Körper verstanden, mit dem das elektronische Bauteil verbunden ist. Beispielsweise kann es sich bei dem Substrat um eine Leiterplatte, um Direct-Bonded-Copper (DBC bzw. DCB) oder um einen Leadframe handeln.

Der Begriff Leiterplatte wird hierin synonym für Leiterkarte, Platine oder gedruckte Schaltung verwendet und beschreibt einen Träger für elektronische Bauteile. Leiterplatten bestehen aus elektrisch isolierendem Material mit daran haftenden, leitenden Verbindungen (Leiterbahnen). Als elektrisch isolierendes Material kann beispielsweise faserverstärkter Kunststoff verwendet werden.

Direct-Bonded-Copper bezeichnet eine keramische Platte (beispielsweise aus Aluminiumoxid, Aluminiumnitrid oder Berylliumoxid), wobei eine Oberfläche oder die beiden flächenmäßig größten, zueinander parallelen Oberflächen mit Kupfer über einen Oxidationsprozess bei hohen Temperaturen gebondet sind. Unter den gewählten Bedingungen bildet sich dabei ein Eutektikum aus Kupfer und Sauerstoff, das sich sowohl mit dem Kupfer als auch dem Oxid des Substrats verbindet.

Unter Leadframe wird ein IC (integrated circuit, Mikrochip)-Gehäuse verstanden, das im Wesentlichen nur aus einem Chipträger und Anschlussleitungen besteht. Der Begriff Leadframe wird hierin synonym mit den Begriffen Anschlussrahmen oder Chipträger verwendet. Der Chipträger weist ein Substrat auf, das dessen Grundgerüst bildet und aus Metall, beispielsweise Kupfer, Kupferlegierungen, einer Kombination von Kupfer mit einem Finisher (z.B. Nickel, Silber oder Gold), Eisen-Nickel-Legierungen oder anderen Invar-Legierungen gefertigt ist.

Das elektronische Bauteil weist wenigstens eine erste Oberfläche auf, die für die Verbindung des elektronischen Bauteils mit einer Oberfläche des Substrats über die durch die Lotpaste geschaffene Kontaktschicht vorgesehen ist. Diese Oberfläche kann auch Teil einer größeren Oberfläche sein.

Das Substrat weist wenigstens eine zweite Oberfläche auf, die für die Verbindung des Substrats mit der vorstehend beschriebenen Oberfläche des elektronischen Bauteils über die durch die Lotpaste geschaffene Kontaktschicht vorgesehen ist. Diese Oberfläche kann ebenfalls auch Teil einer größeren Oberfläche sein.

Die über die durch die Lotpaste geschaffene Kontaktschicht mit dem Substrat in Verbindung stehende Oberfläche des elektronischen Bauteils wird erfindungsgemäß als "erste zu verbindende Oberfläche" und die über die durch die Lotpaste geschaffene Kontaktschicht mit dem elektronischen Bauteil in Verbindung stehende Oberfläche des Substrats als "zweite zu verbindende Oberfläche" bezeichnet.

Üblicherweise ist auf wenigstens der ersten zu verbindenden Oberfläche des elektronischen Bauteils eine Metallisierungsschicht aufgebracht. Ebenfalls üblich ist es, dass auf wenigstens der zweiten zu verbindenden Oberfläche des Substrats eine Metallisierungsschicht aufgebracht ist. Üblicherweise besitzen sowohl elektronisches Bauteil als auch Substrat auf wenigstens den zu verbindenden Oberflächen eine Metallisierungsschicht. Es ist somit üblich, dass das elektronische Bauteil auf einer Oberfläche eine Metallisierungsschicht aufweist, die einer Metallisierungsschicht auf der Oberfläche des Substrats gegenüberliegt, und dass diese Metallisierungsschichten durch die Kontaktschicht miteinander in Verbindung stehen. Im Rahmen der Erfindung sind die üblicherweise vorhandenen Metallisierungsschichten des elektronischen Bauteils Teil des elektronischen Bauteils und die üblicherweise vorhandenen Metallisierungsschichten des Substrats Teil des Substrats.

Falls vorhanden, nimmt die Metallisierungsschicht vorzugsweise einen Flächenanteil von wenigstens 50%, mehr bevorzugt wenigstens 70%, noch mehr bevorzugt wenigstens 90% und ganz bevorzugt wenigstens 95%, wie zum Beispiel 100% von wenigstens einer der Oberflächen des elektronischen Bauteils ein. Auf dem Substrat nimmt die Metallisierungsschicht vorzugsweise einen Flächenanteil von wenigstens 50%, mehr bevorzugt wenigstens 70%, noch mehr bevorzugt wenigstens 90% und ganz bevorzugt wenigstens 95%, wie zum Beispiel 100%, der über die Kontaktschicht mit dem elektronischen Bauteil in Verbindung stehenden Oberfläche ein.

Bei der Metallisierungsschicht handelt es sich vorzugsweise um eine lötbare Schicht. Vorzugsweise enthält die Metallisierungsschicht mindestens ein Element, das aus der Gruppe ausgewählt ist, die aus Kupfer, Silber, Gold, Zinn und Palladium besteht. Die Metallisierungsschicht kann vollständig aus diesen Elementen, lötbaren Verbindungen dieser Elemente oder Mischungen oder Legierungen dieser Elemente bestehen.

Auf wenigstens eine der zu verbindenden Oberflächen von elektronischem Bauteil oder Substrat wird die erfindungsgemäße Lotpaste appliziert.

Bezogen auf ihr Gewicht enthält die erfindungsgemäße Lotpaste (i) 10 - 30 Gew.-%, vorzugsweise 12 - 28 Gew.-% und mehr bevorzugt 15 - 25 Gew.-% mindestens einer Art von jeweils einen Phosphoranteil von > 0 bis ≤ 500 Gewichts-ppm, bevorzugt > 0 bis ≤ 100 Gewichts-ppm, mehr bevorzugt > 0 bis ≤ 50 Gewichts-ppm und insbesondere > 0 bis ≤ 10 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 60 - 80 Gew.-%, vorzugsweise 62 - 78 Gew.-% und mehr bevorzugt 65 - 75 Gew.-% mindestens einer Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (iii) 3 - 30 Gew.-%, vorzugsweise 5 - 20 Gew.-% und mehr bevorzugt 6 - 15 Gew.-% Flussmittel, wobei der mittlere Teilchendurchmesser der metallischen Partikel (i) und (ii) ≤ 15 µm beträgt,
wobei die kupferreichen Kupfer/Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen.

Bevorzugt besteht die erfindungsgemäße Lotpaste, bezogen auf ihr Gewicht, aus (i) 10 - 30 Gew.-%, vorzugsweise 12 - 28 Gew.-% und mehr bevorzugt 15 - 25 Gew.-% mindestens einer Art von jeweils einen Phosphoranteil von > 0 bis ≤ 500 Gewichts-ppm, bevorzugt > 0 bis ≤ 100 Gewichts-ppm, mehr bevorzugt > 0 bis ≤ 50 Gewichts-ppm und insbesondere > 0 bis ≤ 10 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 60 - 80 Gew.-%, vorzugsweise 62 - 78 Gew.-% und mehr bevorzugt 65 - 75 Gew.-% mindestens einer Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (iii) 3 - 30 Gew.-%, vorzugsweise 5 - 20 Gew.-% und mehr bevorzugt 6 - 15 Gew.-% Flussmittel, wobei der mittlere Teilchendurchmesser der metallischen Partikel (i) und (ii) ≤ 15 µm beträgt,
wobei die kupferreichen Kupfer/Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen.

Die Reinheit des Kupfers der in der Lotpaste enthaltenen Kupferpartikel beträgt vorzugsweise wenigstens 99,9 Gew.-% (3 N) und mehr bevorzugt wenigstens 99,99 Gew.-% (4 N). Im Falle der Partikel aus kupferreichen Kupfer/Zink-Legierungen bzw. kupferreichen Kupfer/ZinnLegierungen beträgt die Zusammensetzung 60 bis 99,5 Gew.-% Kupfer und entsprechend 0,5 bis 40 Gew.-% Zink bzw. Zinn. In jedem Falle liegt der Phosphoranteil bei allen Partikeln bei > 0 bis ≤ 500 Gew.-ppm, bevorzugt > 0 bis ≤ 100 Gewichts-ppm, mehr bevorzugt > 0 bis ≤ 50 Gewichts-ppm und insbesondere > 0 bis ≤ 10 Gewichts-ppm. Bevorzugt handelt es sich bei den Partikeln um durch Verdüsung unter Inertgasatmosphäre hergestellte Partikel oder, mit anderen Worten, um durch Verdüsung von flüssigem (geschmolzenem) Kupfer bzw. einer Schmelze einer der besagten Kupferlegierungen in eine Inertgasatmosphäre hinein hergestellte Partikel.

Wie schon gesagt, die Lotpaste enthält ferner mindestens eine Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe. Bei diesen Zinn- bzw. zinnreichen Metallpartikeln handelt es sich um das sogenannte Lot.

Sind in der Lotpaste Lotmetallpartikel aus zinnreichen Zinn/Kupfer-, Zinn/Silber- bzw. Zinn/Kupfer/Silber-Legierungen enthalten, so liegt deren Zinnanteil im Bereich von 95 - 99,5 Gew.-% und der Anteil von Kupfer und/oder Silber dementsprechend im Bereich von 0,5 - 5 Gew.-%.

Die mittleren Teilchendurchmesser der metallischen Partikel (i) und (ii) betragen ≤ 15 µm, vorzugsweise ≤ 13 µm, mehr bevorzugt ≤ 11 µm und noch mehr bevorzugt ≤ 8 µm. Vorzugsweise liegt der mittlere Teilchendurchmesser im Bereich von 2 - 15 µm, mehr bevorzugt im Bereich von 2 - 13 µm, noch mehr bevorzugt im Bereich von 2 - 11 µm und ganz besonders bevorzugt im Bereich von 2 - 8 µm.

Der hierin verwendete Begriff "mittlerer Teilchendurchmesser" bedeutet die mit einem optischen Mikroskop bestimmbare mittlere Teilchengröße (d50). Derartige Messungen können mit einem optischen Mikroskop beispielsweise bei einer 200-fachen Vergrößerung in Kombination mit einem üblichen digitalen Bildverarbeitungssystem (CCD-Digitalkamera und Auswertesoftware), beispielsweise einem Mess-System von Microvision Instruments, durchgeführt werden. Beispielsweise kann ein mittlerer Teilchendurchmesser von ≤ 15 µm bedeuten, dass wenigstens 90 Prozent der Partikel einen Teilchendurchmesser von ≤ 15 µm und weniger als 10 Prozent der Partikel einen Teilchendurchmesser von mehr als 15 µm aufweisen. Ein mittlerer Teilchendurchmesser im Bereich von 2 - 15 µm bedeutet dann dementsprechend, dass wenigstens 90 Prozent der Partikel einen Teilchendurchmesser im Bereich von 2 - 15 µm und weniger als 10 Prozent der Partikel einen Teilchendurchmesser von weniger als 2 µm oder mehr als 15 µm aufweisen.

Erfindungsgemäß kann es bevorzugt sein, dass weniger als 1 Prozent der Partikel (i) und (ii) einen bestimmten Teilchendurchmesser überschreiten. Dieser Teilchendurchmesser, der von weniger als 1 Prozent der Partikel (i) und (ii) überschritten werden darf, beträgt vorzugsweise 15 µm, mehr bevorzugt 11 µm und noch mehr bevorzugt 8 µm.

Die Partikel (i) und (ii) können unterschiedliche Geometrien aufweisen. Die Partikel (i) und (ii) weisen jedoch vorzugsweise eine sphärische Form auf. Dem Fachmann ist jedoch klar, dass von den eingesetzten Partikeln (i) und (ii) herstellungsbedingt auch ein untergeordneter Anteil eine nichtsphärische Form aufweisen kann. Es ist jedoch bevorzugt, dass wenigstens 90 Gew.-%, mehr bevorzugt wenigstens 95 Gew.-%, noch mehr bevorzugt wenigstens 99 Gew.-% oder 100 Gew.-% der Partikel (i) und (ii) in sphärischer Form vorliegen. Es ist auch bevorzugt, dass in der Lotpaste weniger als 5 Gew.-%, mehr bevorzugt weniger als 1 Gew.-%, noch mehr bevorzugt weniger als 0,1 Gew.-%, so zum Beispiel 0 Gew.-% der Partikel (i) und (ii) in der Form von Flakes vorliegen.

Eine Aufgabe des in der Lotpaste enthaltenen Flussmittels ist es, die Oberfläche des Substrats und/oder des elektronischen Bauteils beim Löten zu reduzieren (d.h. zu entoxidieren), die erneute Oxidbildung vor und während des Lötvorgangs zu verhindern und Einschlüsse von Fremdstoffen zu verringern. Ferner soll durch den Zusatz des Flussmittels die Oberflächenspannung des flüssigen Lotes verringert werden. Als Flussmittel können beispielsweise Kolophonium, auf Kolophonium basierende Harzsysteme, auf Wasser basierende Harzsysteme oder Systeme auf der Basis von Carbonsäuren (z.B. Carbonsäuren wie Zitronensäure, Adipinsäure, Zimtsäure und Benzylsäure), Aminen (z.B. tertiäre Amine) und Lösemitteln (z.B. polare Lösemittel, enthaltend Wasser und ein Polyol, wie Glykol oder Glycerin) verwendet werden.

Daneben können in der erfindungsgemäßen Lotpaste weitere Bestandteile, wie zum Beispiel Alkohole, Fettsäuren (z.B. gesättigte Fettsäuren, wie Ölsäure, Myristinsäure, Palmitinsäure, Margarinsäure, Stearinsäure oder Arachinsäure), Polysiloxan-Verbindungen oder Phosphid-Verbindungen, enthalten sein.

Die erfindungsgemäße Lotpaste enthält kein Blei und ist damit bleifrei. Erfindungsgemäß ist unter bleifrei zu verstehen, dass die Lotpaste abgesehen von gegebenenfalls vorhandenen, technisch bedingten Blei-Verunreinigungen kein Blei enthält. Unter bleifrei wird demnach ein Bleigehalt von unter 1, vorzugsweise unter 0,5, mehr bevorzugt unter 0,1, noch mehr bevorzugt unter 0,01 Gew.-% und insbesondere 0 Gew.-% auf Basis des Gewichts der Lotpaste verstanden.

Elektronisches Bauteil und Substrat werden erfindungsgemäß durch Löten stoffschlüssig miteinander verbunden. Stoffschlüssige Verbindungen sind demnach Verbindungen, bei denen die Verbindungspartner durch atomare oder molekulare Kräfte zusammengehalten werden. Sie stellen vorzugsweise nicht lösbare Verbindungen dar, die sich nur durch Zerstörung der Verbindungsmittel trennen lassen.

Erfindungsgemäß wird zunächst eine Anordnung gebildet, die aus dem Substrat, dem elektronischen Bauteil und einer zwischen Substrat und elektronischem Bauteil befindlichen Schicht aus der erfindungsgemäßen Lotpaste besteht. Dementsprechend sind Substrat und elektronisches Bauteil so angeordnet, dass die erste zu verbindende Oberfläche des Substrats und die zweite zu verbindende Oberfläche des elektronischen Bauteils miteinander über die Lotpaste in Kontakt stehen. Üblicherweise steht die Lotpaste dabei vorzugsweise mit der üblicherweise vorhandenen Metallisierungsschicht des Substrats und der üblicherweise vorhandenen Metallisierungsschicht des elektronischen Bauteils in Kontakt.

Vorzugsweise wird dazu zunächst eine Schicht aus der erfindungsgemäßen Lotpaste auf die zu verbindende Oberfläche des Substrats, vorzugsweise auf die eine Metallisierungsschicht aufweisende Oberfläche des Substrats, appliziert. Die Applikation kann durch eines der aus dem Stand der Technik bekannten Verfahren, beispielsweise Siebdruckverfahren, Schablonendruckverfahren, Jet- oder Dispenstechnik, erfolgen. Es ist nicht erforderlich, dass die Lotpaste die gesamte Oberfläche des Substrats bedeckt. Vielmehr kann die Lotpaste auch nur auf Teile der Oberfläche des Substrats, beispielsweise auf ausgewählte Lötflächen, aufgebracht werden. Anschließend wird das elektronische Bauteil mit einer Oberfläche, vorzugsweise mit der die Metallisierungsschicht aufweisenden Oberfläche, auf die applizierte Lotpaste gesetzt.

Die Auftragsdicke der Lotpaste beträgt wenigstens 20 µm, mehr bevorzugt wenigstens 25 µm und noch mehr bevorzugt wenigstens 50 µm. Gemäß einer bevorzugten Ausführungsform liegt die Auftragsdicke im Bereich von 20 -150 µm, mehr bevorzugt im Bereich von 30 -120 µm und besonders bevorzugt im Bereich von 50 - 100 µm. Unter Auftragsdicke wird erfindungsgemäß der Abstand zwischen den zu verbindenden Oberflächen von Substrat und elektronischem Bauteil, vorzugsweise zwischen den Metallisierungsschichten der zu verbindenden Oberflächen von Substrat und elektronischem Bauteil, unmittelbar vor dem Löten verstanden. Die Auftragsdicke wird somit im Wesentlichen von der Menge der verwendeten Lotpaste bestimmt. Beim anschließenden Lötvorgang kommt es zu einer signifikanten Reduzierung des Abstands zwischen elektronischem Bauteil und Substrat, die, je nach genauer Zusammensetzung der Lotpaste, um die 50 Prozent betragen kann.

Die Anordnung aus elektronischem Bauteil, Substrat und dazwischen befindlicher Lotpaste wird schließlich unter Bildung einer Anordnung aus elektronischem Bauteil, Substrat und dazwischenliegender Kontaktschicht gelötet. Unter Löten wird dabei gemäß der allgemeinen Definition ein thermisches Verfahren zum stoffschlüssigen Fügen von Werkstoffen verstanden, wobei die Solidustemperatur der Werkstoffe nicht erreicht wird.

Zum Löten wird die vorstehend beschriebene Anordnung vorzugsweise gleichmäßig bis zum Erreichen der eigentlichen Löttemperatur erhitzt. Gemäß einer bevorzugten Ausführungsform erfolgt das Erhitzen mit einer Geschwindigkeit von ≤ 3 °C pro Sekunde.

Die Löttemperatur liegt vorzugsweise etwa 10 - 50 °C, mehr bevorzugt etwa 15 - 45 °C und noch mehr bevorzugt etwa 25 - 35 °C, zum Beispiel etwa 30 °C über der Schmelztemperatur des verwendeten Lots. Die Löttemperatur liegt im Bereich von 240 - 260 °C.

Zum Löten wird die Temperatur beispielsweise für eine Zeit von wenigstens 15 Sekunden, vorzugsweise von wenigstens 20 Sekunden und noch mehr bevorzugt von wenigstens 30 Sekunden über der Liquidustemperatur des in der erfindungsgemäßen Lotpaste enthaltenen Lots aufrecht erhalten.

Es wird angenommen, dass es während des Abkühlens der gelöteten Anordnung unter die Liquidustemperatur des in der Lotpaste enthaltenen Lots zu einer Diffusion des von den Partikeln vom Typ (i) stammenden Kupfers in eine beim Lötvorgang entstandene eutektische Zinn-Kupfer-Phase kommt.

Es kann vorteilhaft sein, die beim Lötvorgang erhaltene Anordnung aus elektronischem Bauteil, Substrat und dazwischenliegender Kontaktschicht nach dem Lötvorgang zu tempern. Unter Tempern wird eine Wärmebehandlung der Anordnung unterhalb der Liquidustemperatur des Lots verstanden.

Die Wärmebehandlung erfolgt vorzugsweise bei einer Temperatur von über 40 °C, beispielsweise im Bereich von 40 - 217 °C, mehr bevorzugt im Bereich von 100 - 210 °C und noch mehr bevorzugt im Bereich von 150 - 205 °C. Das Tempern erfolgt vorzugsweise für eine Dauer von 1 Minute bis zu 24 Stunden, mehr bevorzugt für 10 Minuten bis zu 10 Stunden und noch mehr bevorzugt für 20 Minuten bis zu 1 Stunde. Die Temperdauer korreliert üblicherweise mit der Temperatur und ist umso länger, je niedriger die Temperatur zum Tempern ist.

Das erfindungsgemäße Verfahren erfordert keine kostspieligen Abänderungen der üblichen Verfahren zur Herstellung von Anordnungen aus elektronischem Bauteil, Substrat und dazwischenliegender Kontaktschicht. Insbesondere stellt das erfindungsgemäße Verfahren auch keine besonderen Anforderungen an die für herkömmliche Lötprozesse verwendeten Maschinen. So kann das erfindungsgemäße Verfahren beispielsweise unter herkömmlichen Bedingungen und unter Einsatz der gegebenenfalls bereits vorhandenen Maschinen durchgeführt werden.

Gemäß einer bevorzugten Ausführungsform ist die erfindungsgemäß erhaltene Anordnung durch das vorstehend beschriebene Verfahren herstellbar oder wird mit diesem Verfahren hergestellt.

In der erfindungsgemäß erhaltenen Anordnung beträgt der Abstand zwischen elektronischem Bauteil und Substrat vorzugsweise 8 - 50 µm, mehr bevorzugt 10 - 30 µm und noch mehr bevorzugt 12 - 28 µm. Dieser Abstand versteht sich als Abstand zwischen den zu verbindenden Oberflächen von elektronischem Bauteil und Substrat, wobei die üblicherweise vorhandenen Metallisierungsschichten dem elektronischen Bauteil bzw. dem Substrat zuzuordnen sind. Der genannte Abstand entspricht somit der Dicke der Kontaktschicht zwischen elektronischem Bauteil und Substrat nach dem Löten.

Erfindungsgemäß können beim vorstehend beschriebenen Lötvorgang die Lötbedingungen, insbesondere Auftragsdicke der Lotpaste, Temperatur und Zeit, sowie ggf. die Temperbedingungen, insbesondere Temperatur und Zeit, so eingestellt werden, dass die vorstehend beschriebene Kontaktschicht erhalten wird. Die Erzeugung der Kontaktschicht mit den gewünschten Eigenschaften kann auf einfache Weise durch Auswertung entsprechender Schliffbilder nachvollzogen werden.

### Beispiele:

### Erfindungsgemäßes Beispiel 1:

Es wurde eine Lotpaste hergestellt, die 69 Gewichtsprozent Partikel einer Zinn-Kupfer-Legierung (SnCu0,7) mit einem mittleren Teilchendurchmesser von 8 µm, 20 Gewichtsprozent Kupferpartikel mit einem mittleren Teilchendurchmesser von 8 µm und einem Phosphoranteil von 5 Gewichts-ppm, und 11 Gewichtsprozent eines Flussmittelsystems auf Kolophoniumbasis enthielt.

Die Lotpaste wurde durch eine Metallschablone auf ein Kupferblech aufgetragen. Die Auftragsdicke der Lotpaste betrug 75 µm. Anschließend wurde die mit Lotpaste versehene Oberfläche des Kupferblechs maschinell mit einem 2 mm x 2 mm großen Nacktchip bestückt, der eine Metallisierungsschicht aus Nickel/Silber aufwies. Hierzu wurde der Nacktchip so auf die Lotpaste gesetzt, dass die Metallisierungsschicht des Nacktchips mit der Oberfläche des Kupferblechs über die Lotpaste in Kontakt stand.

Die Anordnung aus Kupferblech, Nacktchip und dazwischen angeordneter Lotpaste wurde in einen Lötofen eingebracht, mit einer Rate von 2,5 Kelvin pro Sekunde auf eine Temperatur von 260 °C erhitzt und diese Temperatur für 30 Sekunden zum Löten aufrechterhalten.

### Erfindungsgemäßes Beispiel 2:

Es wurde wie in Beispiel 1 gearbeitet mit dem einzigen Unterschied, dass der Phosphoranteil der Kupferpartikel 500 Gewichts-ppm betrug.

### Vergleichsbeispiel 3:

Es wurde wie in Beispiel 1 gearbeitet mit dem einzigen Unterschied, dass der Phosphoranteil der Kupferpartikel 1100 Gewichts-ppm betrug.

### Vergleichsbeispiel 4:

Es wurde wie in Beispiel 1 gearbeitet mit dem einzigen Unterschied, dass der Phosphoranteil der Kupferpartikel 3000 Gewichts-ppm betrug.

### Referenzbeispiel 5:

Es wurde wie in Beispiel 1 gearbeitet, mit dem Unterschied dass die Lotpaste 87 Gewichtsprozent der Partikel der Zinn-Kupfer-Legierung (SnCu0,7) mit einem mittleren Teilchendurchmesser von 8 µm, keine Kupferpartikel und 13 Gewichtsprozent des Flussmittelsystems auf Kolophoniumbasis enthielt.

In verschiedenen Versuchen zur Festigkeit der gemäß den Beispielen 1 bis 5 hergestellten Lötverbindungen bzw. verlöteten Anordnungen wurde festgestellt, dass die Lötverbindungen der gemäß erfindungsgemäßen Beispielen 1 und 2 hergestellten Anordnungen eine wesentlich höhere Scherfestigkeit bei 200 °C aufwiesen als die der gemäß Vergleichsbeispielen 3 und 4 oder gemäß Referenzbeispiel 5 hergestellten Anordnungen.

## Patentansprüche

1. Lotpaste, enthaltend oder bestehend aus (i) 10 - 30 Gew.-% mindestens einer Art von jeweils einen Phosphoranteil von > 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 60 - 80 Gew.-% mindestens einer Art von Partikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (iii) 3 - 30 Gew.-% Flussmittel, wobei der mittlere Teilchendurchmesser der metallischen Partikel (i) und (ii) ≤ 15 µm beträgt,
wobei die kupferreichen Kupfer/Zink-Legierungen oder kupferreichen Kupfer/ZinnLegierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen.

2. Lotpaste nach Anspruch 1,
wobei der Phosphorgehalt > 0 bis ≤ 100 Gewichts-ppm beträgt.

3. Lotpaste nach einem der vorhergehenden Ansprüche,
wobei es sich bei den Partikeln vom Typ (i) um durch Verdüsung unter Inertgasatmosphäre hergestellte Partikel handelt.

4. Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Lotpaste nach einem der vorhergehenden Ansprüche appliziert,
c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und
d) die Anordnung aus c) bei einer im Bereich von 240 - 260 °C liegenden Löttemperatur verlötet, um eine stoffschlüssige Verbindung zwischen dem elektronischen Bauteil und dem Substrat zu erzeugen,
wobei die Auftragsdicke der Lotpaste wenigstens 20 µm beträgt.

5. Verfahren nach Anspruch 4,
wobei das elektronische Bauteil ein Chip, eine Halbleiterdiode, ein Transistor, ein Widerstand oder ein Kondensator ist.

6. Verfahren nach Anspruch 4 oder 5,
wobei das Substrat eine Leiterplatte, ein Direct-Bonded-Copper oder ein Leadframe ist.

7. Verfahren nach einem der Ansprüche 4 bis 6,
wobei die Applikation der Lotpaste durch Siebdruckverfahren, Schablonendruckverfahren, Jet- oder Dispenstechnik erfolgt.

8. Verfahren nach einem der Ansprüche 4 bis 7,
wobei die nach Abschluß von Schritt d) erhaltene Anordnung bei einer Temperatur im Bereich von 40 - 217 °C für eine Dauer von 1 Minute bis zu 24 Stunden getempert wird.

## Claims

1. Solder paste, containing or consisting of (i) 10 - 30% by weight of at least one type of particles, which each comprise a phosphorus fraction ranging from > 0 to ≤ 500 wt-ppm and are selected from the group consisting of copper particles, copper-rich copper/zinc alloy particles, and copper-rich copper/tin alloy particles, (ii) 60 - 80% by weight of at least one type of particles selected from the group consisting of tin particles, tin-rich tin/copper alloy particles, tin-rich tin/silver alloy particles, and tin-rich tin/copper/silver alloy particles, and (iii) 3 - 30% by weight flux, whereby the mean particle diameter of the metallic particles (i) and (ii) is ≤ 15 µm,
whereby the copper-rich copper/zinc alloys or copper-rich copper/tin alloys comprise a composition of 60 to 99.5% by weight copper and 0.5 to 40% by weight zinc or tin, and
whereby the tin-rich tin/copper, tin/silver or tin/copper/silver alloys comprise a composition of 95 - 99.5% by weight tin and 0.5 - 5% by weight copper, silver or copper plus silver.

2. Solder paste according to claim 1,
whereby the phosphorus content ranges from > 0 to ≤ 100 wt-ppm.

3. Solder paste according to any one of the preceding claims,
whereby the particles of type (i) are particles produced by atomisation in an inert gas atmosphere.

4. Method for firmly bonded connecting of an electronic component to a substrate, wherein
a) an electronic component with a first surface to be connected and a substrate with a second surface to be connected are provided;
b) a solder paste according to any one of the preceding claims is applied to at least one of the surfaces to be connected;
c) the electronic component and the substrate are arranged appropriately such that the first surface of the electronic component to be connected and the second surface of the substrate to be connected are contacted to each other by means of the solder paste; and
d) the arrangement from c) is soldered at a soldering temperature ranging from 240 - 260°C in order to generate a firmly bonded connection between the electronic component and the substrate;
whereby the application thickness of the solder paste is at least 20 µm.

5. Method according to claim 4,
whereby the electronic component is a chip, a semiconductor diode, a transistor, a resistor or a capacitor.

6. Method according to claim 4 or 5,
whereby the substrate is a printed circuit board, a direct-bonded-copper or a leadframe.

7. Method according to any one of the claims 4 to 6,
whereby the application of the solder paste takes place by screen printing procedure, stencil printing procedure, jet or dispensing technique.

8. Method according to any one of the claims 4 to 7,
whereby the arrangement obtained after completion of step d) is tempered at a temperature ranging from 40 - 217°C for a period ranging from 1 minute up to 24 hours.

## Revendications

1. Pâte à braser contenant ou constituée de (i) 10 à 30 % en poids d'au moins un type de particules présentant chacune une proportion de phosphore de > 0 à ≤ 500 ppm en poids sélectionnées parmi le groupe constitué de particules de cuivre, de particules d'alliage de cuivre/zinc riches en cuivre et de particules d'alliage de cuivre/étain riches en cuivre, (ii) 60 à 80 % en poids d'au moins un type de particules sélectionnées parmi le groupe constitué de particules d'étain, de particules d'alliage d'étain/cuivre riches en étain, de particules d'alliage d'étain/argent riches en étain et de particules d'alliage d'étain/cuivre/argent riches en étain, et (iii) 3 à 30 % en poids de flux, dans laquelle le diamètre particulaire moyen des particules métalliques (i) et (ii) se monte à ≤ 15 µm,
dans laquelle les alliages de cuivre/zinc riches en cuivre ou alliages de cuivre/étain riches en cuivre présentent une composition de 60 à 99,5 % en poids de cuivre et 0,5 à 40 % en poids de zinc ou d'étain, et
dans laquelle les alliages d'étain/cuivre, d'étain/argent ou d'étain/cuivre/argent riches en étain présentent une composition de 95 à 99,5 % en poids d'étain et 0,5 à 5 % en poids de cuivre, argent ou cuivre plus argent.

2. Pâte à braser selon la revendication 1,
dans laquelle la teneur en phosphore se monte à > 0 à ≤ 100 ppm en poids.

3. Pâte à braser selon une des revendications précédentes,
dans laquelle il s'agit pour les particules du type (i) de particules fabriquées par atomisation sous atmosphère de gaz inerte.

4. Procédé de connexion par liaison de matière d'un composant électronique à un substrat, lors duquel on
a) met à disposition un composant électronique avec une première surface à connecter et un substrat avec une seconde surface à connecter,
b) applique sur au moins une des surfaces à connecter une pâte à braser selon une des revendications précédentes,
c) agence le composant électronique et le substrat de sorte que la première surface à connecter du composant électronique est en contact avec la seconde surface à connecter du substrat par le biais de la pâte à braser, et
d) brase l'agencement de c) à une température de brasage située dans la région de 240 à 260°C pour générer une connexion par liaison de matière entre le composant électronique et le substrat,
dans lequel l'épaisseur d'application de la pâte à braser se monte à au moins 20 µm.

5. Procédé selon la revendication 4,
dans lequel le composant électronique est une puce, une diode semiconductrice, un transistor, une résistance ou un condensateur.

6. Procédé selon la revendication 4 ou 5,
dans lequel le substrat est une plaquette, un substrat DBC ou une grille de connexion.

7. Procédé selon une des revendications 4 à 6,
dans lequel l'application de la pâte à braser s'effectue par un procédé de sérigraphie, procédé d'impression au pochoir, technique par jet ou dispensing.

8. Procédé selon une des revendications 4 à 7,
dans lequel l'agencement obtenu à la fin de l'étape d) est recuit à une température dans la région de 40 à 217°C pendant une durée de 1 minute à 24 heures.
